# EUROPÄISCHE PATENTSCHRIFT

(11) **EP 4 038 843 B1**
(45) Veröffentlichungstag und Bekanntmachung des Hinweises auf die Patenterteilung: **13.11.2024**
(21) Anmeldenummer: 20771983.2
(22) Anmeldetag: 09.09.2020
(51) Int. Cl.: H04L 12/40

(54) **BUSSYSTEM UND VERFAHREN ZUM BETREIBEN EINES BUSSYSTEMS**
BUS SYSTEM AND METHOD FOR OPERATING A BUS SYSTEM
SYSTÈME DE BUS ET PROCÉDÉ D'EXPLOITATION D'UN SYSTÈME DE BUS

(30) Priorität: 02.10.2019 DE 102019006875
(43) Veröffentlichungstag der Anmeldung: 10.08.2022
(73) Patentinhaber: SEW-Eurodrive GmbH & Co, 76646 Bruchsal (DE)
(72) Erfinder: KOLLAR, Hans Jürgen, 76646 Bruchsal (DE)
(86) Internationale Anmeldenummer: PCT/EP2020/025402
(87) Internationale Veröffentlichungsnummer: WO 2021/063537

(56) Entgegenhaltungen:
- EP-A1- 2 154 831
- DE-B3- 10 261 174

## Beschreibung

Die Erfindung betrifft ein System und ein Verfahren zum Betreiben eines Systems.

Aus der EP 2 232 829 B1 ist eine selbst initialisierende Schnittstelle bekannt.

**Aus der** DE 10 2018 104 873 A1 **ist ein Autoadressierungsverfahren zur Vergabe von Busknotenadressen innerhalb eines Datenbussystems mit einem Kommunikationsbus mit Busknoten und einem Busmaster bekannt.**

**Aus der** US 2016 / 0 254 925 A1 **ist bekannt, eine Busknotenadresse und gegebenenfalls den Busknotenabschluss eines Busknotens basierend auf der Verkabelung des Busses im Bus über eine Initialisierungsphase einstellen zu können.**

**Aus der** US 2010 / 0 274 945 A1 **ist ein System zum Adressieren von Knoten in einem drahtgebundenen Multi-Drop-Netzwerk offenbart.**

**Aus der** DE 102 61 174 B3 **ist als nächstliegender Stand der Technik eine automatische Adressierung auf Bussystemen bekannt.**

**Aus der** EP 2 154 831 A1 **ist ein Verfahren zur Bestimmung der Adresse oder Position eines Teilnehmers bekannt.**

Der Erfindung liegt daher die Aufgabe zugrunde, die Adressvergabe bei einem Bussystem weiterzubilden.

Erfindungsgemäß wird die Aufgabe bei dem System nach den in Anspruch 1 und bei dem Verfahren nach den in Anspruch **9** angegebenen Merkmalen gelöst.

Masse bedeutet hier stets das Bezugspotential, also das untere Potential der als Gleichspannung ausgeführten Versorgungsspannung.

Wichtige Merkmale der Erfindung bei dem System, aufweisend eine Steuerung und zumindest einen ersten Busteilnehmer und einen Nachfolger, also zweiten Busteilnehmer sind, dass die Steuerung mit dem ersten Busteilnehmer mittels eines Datenbusses, insbesondere CAN-Bus, RS485-Bus oder dergleichen, verbunden, insbesondere seriell verbunden, ist und der Nachfolger verbindbar ist,
wobei jeder Busteilnehmer, insbesondere der erste Busteilnehmer, jeweils eine erste Schaltungsanordnung aufweist, die zwischen einem Ausgang OUT des ersten Busteilnehmers und einem Eingang IN des ersten Busteilnehmers angeordnet ist,
der Nachfolger eine zweite Schaltungsanordnung aufweist, die zwischen einem Ausgang OUT des Nachfolgers und einem Eingang IN des Nachfolgers angeordnet ist,
wobei die erste und zweite Schaltungsanordnung baugleich und/oder gleichartig ausgeführt sind,
wobei die erste und zweite Schaltungsanordnung einen Anschluss für eine Versorgungsspannung aufweisen,
wobei die erste Schaltungsanordnung ein Mittel zur Erfassung der am Ausgang OUT, insbesondere gegen Masse, anliegenden Spannung aufweist,
wobei ein erster Widerstand R4 zwischen dem Ausgang OUT und dem Anschluss für Versorgungsspannung angeordnet ist,
wobei ein zweiter Widerstand R2 zwischen dem Eingang IN und einem Anschluss für Masse angeordnet ist,
wobei mittels eines ersten steuerbaren Halbleiterschalters ein dritter Widerstand R1 zwischen dem Eingang IN und dem Anschluss für Versorgungsspannung anordenbar ist, insbesondere so dass der dritte Widerstand R1 parallel zum ersten Widerstand R4 angeordnet ist bei Verbinden des Nachfolgers mit dem ersten Busteilnehmer,
wobei mittels eines zweiten steuerbare Halbleiterschalters ein vierter Widerstand R3 zwischen dem Ausgang OUT und dem Anschluss für Versorgungsspannung anordenbar ist, insbesondere so dass der vierte Widerstand R3 parallel zum dritten Widerstand R1 angeordnet ist bei Verbinden des Nachfolgers mit dem ersten Busteilnehmer.

Von Vorteil ist dabei, dass abhängig von dem Aktivierungszustand der Halbleiterschalter und abhängig vom Verbindungszustand des ersten Busteilnehmers mit dem Nachfolger die Spannung am Ausgang des ersten Busteilnehmers bewirkbar ist. Somit ist das Anschließen des Nachfolgers an den ersten Busteilnehmer von diesem bemerkbar, indem die entsprechende Spannung am Ausgang OUT des ersten Busteilnehmers detektiert wird. Dabei ist außerdem aus dem jeweils erfassten Spannungswert detektierbar, ob der Nachfolger von einer Versorgungsspannung versorgt wird oder nicht. Des Weiteren ist bestimmbar, ob der Eingang des Nachfolgers aktiviert ist oder nicht, insbesondere also der erste steuerbare Halbleiterschalter des Nachfolgers im leitenden Zustand ist oder nicht.

Somit ist also auch die Anforderung nach Vergabe einer Busadresse detektierbar und vom ersten Busteilnehmer weitermeldbar über den Datenbus, da der Nachfolger noch keine Adresse zugewiesen bekommen hat. Wenn also der Nachfolger korrekt, das heißt von einer Versorgungsspannung versorgt, an den ersten Busteilnehmer angeschlossen ist und seinen Eingang aktiviert, wird vom ersten Busteilnehmer an die Steuerung die Anforderung nach Vergabe einer Adresse über den Datenbus verschickt. Dieser Datenbus ist ebenfalls seriell von der Steuerung über den ersten Busteilnehmer bis zum neu angeschlossenen Nachfolger durchgeschleift; jedoch ist der Ausgang und der Eingang separat vom Datenbus vorgesehen. Die Erfindung erfordert also eine zum Datenbus zusätzliche Verbindungsleitung zwischen dem ersten Busteilnehmer und dem Nachfolger, insbesondere zwischen dem Ausgang des ersten Busteilnehmers und dem Eingang des Nachfolgers.

Erfindungsgemäß ist also eine selbstinitialisierende Schnittstelle realisiert, da beim Anfügen eines jeweils nächsten Busteilnehmers eine Busadresse an diesen Busteilnehmer automatisch vergeben wird.

Vorzugsweise sind die Busteilnehmer, insbesondere also auch der Nachfolger, jeweils als Wechselrichter ausgeführt.

Bei einer vorteilhaften Ausgestaltung weist der Eingang IN des Nachfolgers mit dem Ausgang OUT des ersten Busteilnehmers verbindbar ist. Von Vorteil ist dabei, dass der Nachfolger anschließbar ist an den ersten Busteilnehmer, wobei dann eine elektrische Verbindung vom Ausgang OUT des ersten Busteilnehmers zum Eingang IN des Nachfolgers vorgesehen wird.

Bei einer vorteilhaften Ausgestaltung weist der Nachfolger ein Mittel zur Erfassung der am Eingang IN des Nachfolgers, insbesondere gegen Masse, anliegenden Spannung auf,
insbesondere wobei der Nachfolger ein Mittel zur Erfassung der am Ausgang OUT des Nachfolgers, insbesondere gegen Masse, anliegenden Spannung aufweist. Von Vorteil ist dabei, dass vom Nachfolger detektierbar ist, ob sein Eingang mit dem Ausgang OUT des ersten Busteilnehmers verbunden ist oder nicht. Sobald er dieses Verbinden detektiert hat,
aktiviert er seinen Eingang IN und ermöglicht somit das Absenden der Anforderung einer neuen Busadresse, wobei diese Anforderung durch den ersten Busteilnehmer erfolgt.

Bei einer vorteilhaften Ausgestaltung weist der erste Busteilnehmer ein Mittel zur Erfassung der am Eingang IN des ersten Busteilnehmers, insbesondere gegen Masse, anliegenden Spannung auf. Von Vorteil ist dabei, dass der erste Busteilnehmer bei seinem eingangsseitigen Verbinden mit einem Vorgänger, wie beispielsweise die Steuerung oder einem anderen Busteilnehmer, ebenso agieren kann wie auch der Nachfolger es bei seinem Anschließen an den ersten Busteilnehmer.
**Erfindungsgemäß** ist der Nachfolger und / oder der erste Busteilnehmer an seinem Eingang IN eine erste Schutzbeschaltung gegen zu niedrige und/oder zu hohe Spannungen angeordnet,
wobei am Ausgang OUT eine zweite Schutzbeschaltung gegen zu niedrige und/oder zu hohe Spannungen angeordnet ist. Von Vorteil ist dabei, dass ein Schutz gegen Überspannung und zu niedrige Spannung vorsehbar ist.
**Erfindungsgemäß** ist zwischen dem Eingang IN und Masse ein erster Kondensator angeordnet,
wobei zwischen dem Ausgang OUT und Masse ein zweiter Kondensator angeordnet ist. Von Vorteil ist dabei, dass die jeweiligen Spannungen geglättet sind und/oder für Hochfrequenz ein Kurzschluss realisiert ist.
**Erfindungsgemäß** weist die erste Schutzbeschaltung einen zwischen dem Eingang IN und einer ersten Diode angeordneten Widerstand R6 auf,
wobei die erste Diode derart zwischen dem Widerstand R6 und dem Anschluss für Versorgungsspannung angeordnet ist, dass dem Anschluss für Versorgungsspannung Strom durch die erste Diode hindurch zugeleitet wird, wenn am Eingang IN eine höhere Spannung als die Versorgungsspannung anliegt,
wobei eine zweite Diode zwischen dem Widerstand R6 und Masse derart angeordnet ist, dass der Masse Strom durch die zweite Diode hindurch zugeleitet wird, wenn am Eingang IN eine negative Spannung anliegt. Von Vorteil ist dabei, dass die Schutzbeschaltung in einfacher Weise realisierbar ist.

Bei einer vorteilhaften Ausgestaltung weist die zweite Schutzbeschaltung einen zwischen dem Ausgang OUT und einer dritten Diode angeordneten Widerstand R7 auf,
wobei die dritte Diode derart zwischen dem Widerstand R7 und dem Anschluss für Versorgungsspannung angeordnet ist, dass dem Anschluss für Versorgungsspannung Strom durch die dritte Diode hindurch zugeleitet wird, wenn am Ausgang OUT eine höhere Spannung als die Versorgungsspannung anliegt,
insbesondere wobei eine vierte Diode zwischen dem Widerstand R7 und Masse derart angeordnet ist, dass der Masse Strom durch die vierte Diode hindurch zugeleitet wird, wenn am Ausgang OUT eine negative Spannung anliegt. Von Vorteil ist dabei, dass die Schutzbeschaltung in einfacher Weise realisierbar ist.

Bei einer vorteilhaften Ausgestaltung sind der erste und der zweite steuerbare Halbleiterschalter der ersten Schaltungsanordnung in einem ersten Bauteil integriert angeordnet. Von Vorteil ist dabei, dass eine kostengünstige Fertigung mittels SMD-Bestückung ausführbar ist. Die Schaltung ist somit in einfacher Weise realisierbar.

Bei einer vorteilhaften Ausgestaltung sind die erste, zweite, dritte, vierte Diode der ersten Schaltungsanordnung in einem zweiten Bauteil integriert angeordnet. Von Vorteil ist dabei, dass eine kostengünstige einfache Bestückung realisierbar ist. Durch die so erreichbare Verringerung der Anzahl der Bauteile ist eine einfache kostengünstige Fertigung erreichbar und ein robustes Endprodukt.

Bei einer vorteilhaften Ausgestaltung weist die erste Schaltungsanordnung eine Leiterplatte auf, auf welcher das erste und das zweite Bauteil bestückt sind, insbesondere mittels SMD-Technik. Von Vorteil ist dabei, dass das Bauteil robust ausführbar ist und somit die eine Verringerung der Anzahl der Bauteile erreichbar ist.

Wichtige Merkmale bei dem Verfahren zum Betreiben eines Systems sind, dass das System eine Steuerung aufweist und zumindest einen ersten Busteilnehmer und einen Nachfolger, also zweiten Busteilnehmer,
wobei die Steuerung mit dem ersten Busteilnehmer mittels eines Datenbusses, insbesondere CAN-Bus, RS485-Bus oder dergleichen, verbunden, insbesondere seriell verbunden, ist und der Nachfolger verbindbar ist,
wobei jeder Busteilnehmer, insbesondere der erste Busteilnehmer, jeweils einen aktivierbaren Ausgang und einen aktivierbaren Eingang aufweist,
wobei der Nachfolger ebenfalls einen aktivierbaren Ausgang und einen aktivierbaren Eingang aufweist,
wobei jeder Ausgang abhängig von seiner Aktivierung einen ersten oder zweiten Widerstandswert zu einem Anschluss für Versorgungsspannung aufweist,
wobei jeder Eingang abhängig von seiner Aktivierung einen dritten oder vierten Widerstandswert insbesondere vom Ausgang zur elektrischen Erde, insbesondere Nullpotential oder Masse, hin des Nachfolgers aufweist,
wobei die am Ausgang des ersten Busteilnehmers anliegende Spannung erfasst wird und abhängig von der erfassten Spannung unter Berücksichtigung des Aktivierungszustands des Ausgangs des ersten Busteilnehmers erkannt wird,
   - ob mit dem ersten Busteilnehmer kein Nachfolger verbunden ist, insbesondere also der Ausgang offen ist,
   - ob mit dem ersten Busteilnehmer ein Nachfolger verbunden ist, der keine Versorgungsspannung aufweist,
   - ob mit dem ersten Busteilnehmer ein Nachfolger verbunden ist, der von einer Versorgungsspannung versorgt ist und dessen Eingang aktiviert ist,
   - ob mit dem ersten Busteilnehmer ein Nachfolger verbunden ist, der von einer Versorgungsspannung versorgt ist und dessen Eingang nicht aktiviert ist,
   - ob mit dem ersten Busteilnehmer ein Abschlussstecker verbunden ist, insbesondere also der Ausgang elektrisch mit Masse verbunden ist.

Von Vorteil ist dabei, dass zunächst die Spannung am Ausgang erfasst wird und dann bestimmt wird, in welchen Spannungsbereich diese Spannung fällt. Vom detektierten und/oder bestimmten Spannungsbereich abhängig wird dann gemäß der damit verbundenen Information eine weitere Aktion eingeleitet. Beispielsweise wird bei Detektieren des Abschlusssteckers die Inbetriebnahme abgeschlossen und der reguläre Betrieb aufgenommen. Bei Detektieren eines Nachfolgers wird eine Adressvergabe eingeleitet und danach auf die die Aktivierung des Eingangs des Nachfolgers gewartet, also die Quittierung des Empfangs der neuen Adresse durch den Nachfolger. Zwar muss jeder Busteilnehmer, insbesondere also der erste Busteilnehmer und der Nachfolger, am Datenbus angeschlossen sein; jedoch ist für die Ausführung der Erfindung nur eine Meldeleitung zusätzlich notwendig, welche den jeweiligen Ausgang eines vorhergehenden Busteilnehmers mit dem Eingang eines nachfolgendenden Busteilnehmers, insbesondere Nachfolgers, verbindet.

Durch die Aktivierung oder Deaktivierung des zweiten steuerbaren Halbleiterschalters des ersten Busteilnehmers lassen sich verschiedene Informationen codieren, die der Nachfolger dekodieren kann. Ebenso lassen sich durch Aktivieren oder Deaktivieren des ersten steuerbaren Schalters, also des Eingangs, des Nachfolgers Informationen für den ersten Busteilnehmer codieren.

Bei einer vorteilhaften Ausgestaltung wird entschieden, ob die erfasste Spannung in einem ersten, zweiten, dritten oder vierten Spannungsbereich enthalten ist,
wobei der erste Spannungsbereich oberhalb des zweiten Spannungsbereich ist, wobei der zweite Spannungsbereich oberhalb des dritten Spannungsbereichs ist,
wobei der dritte Spannungsbereich oberhalb des vierten Spannungsbereichs ist,
   - **wobei der erste** Spannungsbereich die Information codiert, dass mit dem ersten Busteilnehmer kein Nachfolger verbunden ist, insbesondere also der Ausgang offen ist,
   - **wobei der dritte** Spannungsbereich die Information codiert, dass mit dem ersten Busteilnehmer ein Nachfolger verbunden ist, der keine Versorgungsspannung aufweist,
   - **wobei ein weiterer** Spannungsbereich die Information codiert, dass mit dem ersten Busteilnehmer ein Nachfolger verbunden ist, der von einer Versorgungsspannung versorgt ist und dessen Eingang aktiviert ist,
   - **wobei der zweite** Spannungsbereich die Information codiert, dass mit dem ersten Busteilnehmer ein Nachfolger verbunden ist, der von einer Versorgungsspannung versorgt ist und dessen Eingang nicht aktiviert ist,
   - wobei der **vierte** Spannungsbereich die Information codiert, dass mit dem ersten Busteilnehmer ein Abschlussstecker verbunden ist, insbesondere also der Ausgang elektrisch mit Masse verbunden ist.

Von Vorteil ist dabei, dass nach Erfassen der Spannung am Ausgang des ersten Busteilnehmers derjenige Spannungsbereich bestimmt wird, in welchem der erfasste Wert der Spannung enthalten ist. Da zu jedem der Spannungsbereiche eine entsprechend zugeordnete Information gehört, ist entsprechend dieser Information eine weitere Aktion ausführbar. Wenn beispielsweise festgestellt wird, dass der Nachfolger zwar verbunden aber nicht versorgt ist, ist einen Fehlermeldung anzeigbar. Wenn der Nachfolger jedoch verbunden ist und versorgt ist, wobei sein Eingang nicht aktiviert ist, fordert der erste Busteilnehmer eine Busadresse für den Nachfolger an, wobei die Steuerung als Busmaster fungiert und die Adresse dann über die Datenbusleitung sendet, so dass nach Empfang dieser Busadresse der Nachfolger diese Adresse annimmt und diese Annahme mittels Aktivieren seines Eingangs quittiert. Somit muss der erste Busteilnehmer nicht nochmals oder weiterhin die Busadresse für den Nachfolger anfordern.

Um die Sicherheit der Zustandsbestimmung des Nachfolgers weiter zu erhöhen, wird die Spannung am Ausgang des ersten Busteilnehmers nicht nur bei deaktiviertem Ausgang gemessen, sondern auch bei aktiviertem Ausgang des ersten Busteilnehmers. Somit ist der Zustand des Nachfolgers möglichst sicher bestimmbar.

Bei einer vorteilhaften Ausgestaltung wird abhängig von der erfassten Spannung und abhängig von dem Aktivierungszustand des Ausgangs des ersten Busteilnehmers
- ein jeweiliger Zustand, insbesondere Fehlerzustand, vom ersten Busteilnehmer gemeldet
oder die Vergabe einer Adresse wird angefordert, insbesondere der Empfang der Adresse insbesondere vom Nachfolger, quittiert wird. Von Vorteil ist dabei, dass die Steuerung über den Zustand des Nachfolgers ebenfalls informiert wird und somit auch davon abhängig Aktionen vom ersten Busteilnehmer auslösbar sind.

Weitere Vorteile ergeben sich aus den Unteransprüchen.

Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:
In der Figur 1 ist ein Bussystem gezeigt, das eine Steuerung 1 und seriell angeordnete Busteilnehmer 2, insbesondere Wechselrichter, sowie einen Abschlussstecker schematisch skizziert darstellt.
In der Figur 2 sind zwei Busteilnehmer 2 dargestellt, wobei der Ausgang OUT eines ersten Busteilnehmers 2 mit dem Eingang IN eines zweiten Busteilnehmers 2 verbunden ist.
In der Figur 3 ist eine zwischen dem Eingang IN und dem Ausgang OUT in einem Busteilnehmer 2 angeordnete Schaltungsanordnung dargestellt.

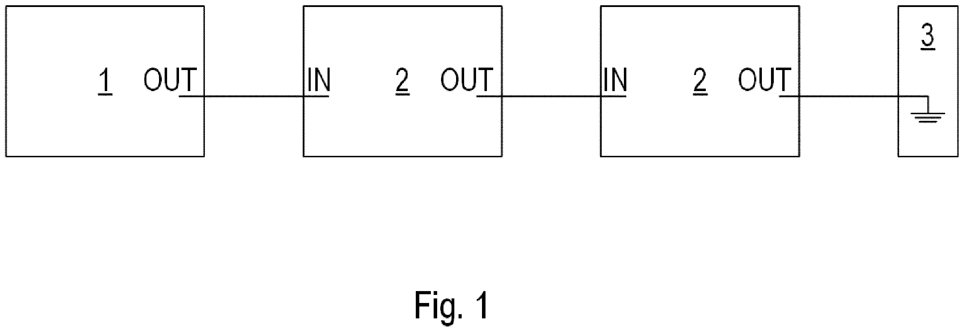

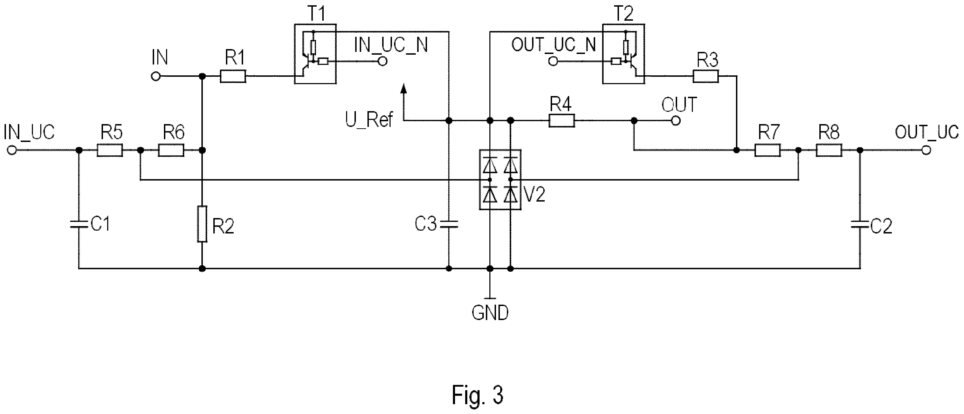

Wie in Figur 1 bis Figur 3 dargestellt, ist ein Ausgang OUT der Steuerung 1 mit einem Eingang IN eines ersten der Busteilnehmer 2 verbunden, der wiederum mit einem weiteren Busteilnehmer 2 verbunden ist. An dessen Ausgang OUT ist direkt ein Abschlussstecker 3 angeschlossen oder ein oder mehrere in Reihe vorgesehene Busteilnehmer 2, wobei dann am letzten der Busteilnehmer der Abschlussstecker 3 angeschlossen ist.

Jeder Busteilnehmer 2 weist zwischen seinem Eingang IN und seinem Ausgang OUT eine Schaltungsanordnung auf.

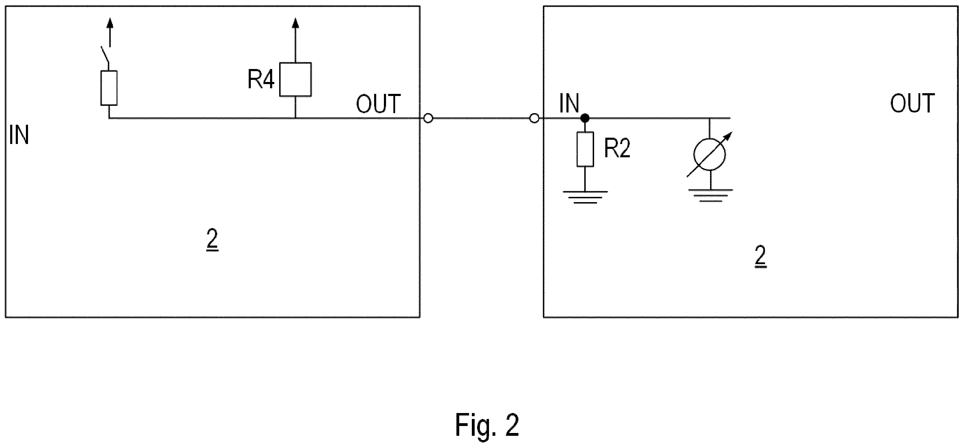

Wie in Figur 2 gezeigt, weist diese Schaltungsanordnung einen Widerstand R4 auf, der zwischen dem Ausgang OUT des Busteilnehmers 2 und einem Anschluss, der ein oberes Potential einer Versorgungsspannung U_REF führt, angeordnet ist. Dabei ist dieses obere Potential nur dann vorhanden, wenn eine entsprechende Versorgungsspannungsquelle vorhanden ist.

Außerdem weist diese Schaltungsanordnung einen Widerstand R2 auf, der zwischen dem Eingang IN des Busteilnehmers 2 und Masse, insbesondere also einem Anschluss, der ein unteres Potential einer Versorgungsspannung U_REF führt, angeordnet ist.

Die beiden Widerstände R2 und R4 sind vorzugsweise gleich groß gewählt.

Die Schaltungsanordnung weist außerdem ein Spannungserfassungsmittel auf, welches die am Widerstand R2 anliegende Spannung erfasst. Wenn keine Versorgungsspannung vorhanden ist, weist das Spannungserfassungsmittel ist der Eingangswiderstand des Spannungserfassungsmittels dem Widerstand R2 parallelgeschaltet, so dass der aus dem Widerstand R4 und der aus dem Widerstand R2 zusammen mit dem Eingangswiderstand gebildete Spannungsteiler die Spannung weiter herunterteilt als bei Nicht-Vorhandensein des Eingangswiderstands.

Das Spannungserfassungsmittel erfasst die an IN_UC anliegende Spannung.

Eine Eingangsschutzbeschaltung ist aus einem Kondensator C1, einem Widerstand R5, einem Widerstand R6, und einer Diodenbrückenanordnung V2 gebildet. Hierzu ist der Kondensator C1 zwischen dem Eingang des Spannungserfassungsmittels und Masse angeordnet, so dass ein Kurzschluss für Hochfrequenz gebildet ist und die zu messende Spannung geglättet ist.

Die Diodenbrückenanordnung V2 weist zwei zueinander parallel geschaltete Reihenschaltungen auf, wobei jede der Reihenschaltungen zwei in Reihe geschaltete Dioden aufweist. Die Reihenschaltungen sind aus der Versorgungsspannung gespeist, wobei die Dioden in Sperrrichtung angeordnet sind, wenn das obere Potential oberhalb Masse liegt.

Der Ausgang OUT ist über den Widerstand R5 mit dem Verbindungsknoten der beiden Dioden der ersten Reihenschaltung verbunden. Zwischen diesem Verbindungsknoten und Masse ist eine Reihenschaltung, die aus den beiden Widerständen R6 und R2 gebildet ist, angeordnet.

Der Eingang IN ist mit dem Verbindungsknoten, an welchem die beiden Widerstände R6 und R2 verbunden sind, verbunden.

Eine Ausgangsschutzbeschaltung ist aus einem Kondensator C2, einem Widerstand R7, einem Widerstand R8, und der Diodenbrückenanordnung V2, insbesondere der zweiten Reihenschaltung der Diodenbrückenanordnung V2, gebildet. Hierzu ist der Kondensator C2 zwischen dem Eingang des Spannungserfassungsmittels und Masse angeordnet, so dass ein Kurzschluss für Hochfrequenz gebildet ist und die zu messende Spannung geglättet ist. Der Ausgang OUT ist über den Widerstand R7 mit dem Verbindungsknoten der beiden Dioden der ersten Reihenschaltung verbunden. Zwischen diesem Verbindungsknoten und dem zweiten Kondensator C2 ist der Widerstand R8 angeordnet. Über den Widerstand R4 ist der Ausgang OUT mit der Versorgungsspannung verbunden.

Mittels Ansteuerung eines zweiten steuerbaren Halbleiterschalters T2, insbesondere Transistors, ist der Ausgang OUT über den Widerstand R3 mit der Versorgungsspannung verbunden. Da somit dann der Widerstand R3 mit dem Widerstand R4 parallelgeschaltet ist, ist bei jeweils gleicher Dimensionierung der effektive Widerstand zwischen dem Ausgang OUT und der Versorgungsspannung halbiert. Beim Verbinden des nachfolgenden Busteilnehmers 2, also dem Verbinden des Ausgangs OUT mit dem Eingang IN des nachfolgenden Busteilnehmers 2, teilt der durch die Reihenschaltung der aus den Widerständen R3 und R4 gebildeten Parallelschaltung mit dem Widerstand R2 des nachfolgenden Busteilnehmers 2
Gebildete Spannungsteiler die Versorgungsspannung auf zwei Drittel der Versorgungsspannung herab.

Wenn am Ausgang OUT der Abschlussstecker 3 angeschlossen ist, also der Ausgang OUT mit Masse direkt elektrisch verbunden ist, wird dort eine Spannung von 0 Volt oder zumindest nahe bei 0 Volt erfasst. Somit ist der Abschlussstecker 3 erkennbar.

Wenn am Ausgang OUT jedoch kein nachfolgender Busteilnehmer 2 angeschlossen ist und somit der Ausgang OUT offen ist, kann der Busteilnehmer 2 an seinen Vorgänger diese Information übermitteln, indem durch Ansteuern eines ersten steuerbaren Halbleiterschalters T1, insbesondere Transistors, der Eingang IN über den Widerstand R1 mit der Versorgungsspannung verbunden wird. Somit ergibt sich durch den mit dem Widerstand R4 des Vorgängers gebildeten Spannungsteiler eine herabgeteilte Spannung am Eingang IN von zwei Dritteln der Versorgungsspannung, wenn der Vorgänger seinen zweiten Transistor T2 noch nicht aktiviert hat. Wenn er jedoch seinen zweiten Transistor T2 aktiviert hat, ergibt sich durch den Spannungsteiler ein Herabteilen auf drei Vierteil der Versorgungsspannung. Denn der Spannungsteiler ist dann aus einer Reihenschaltung gebildet, die bei welcher der Widerstand R2 des Busteilnehmers in Reihe geschaltet ist mit der Parallelschaltung, welche die Widerstände R1 des Busteilnehmers und die Widerstände R3 und R4 des Vorgängers aufweist.

Durch Ansteuern des ersten steuerbaren Halbleiterschalters T1 des Vorgängers eines Busteilnehmers 2 ist also eine Adressvergabe an den Busteilnehmer 2 einleitbar.

Durch Ansteuern des zweiten steuerbaren Halbleiterschalters T2 des Busteilnehmers 2 und danach Anschließen des Nachfolgers an den Busteilnehmer 2, wobei der erste steuerbare Halbleiterschalter T1 des Nachfolgers aktiviert wird, ist also drei Viertel der Versorgungsspannung am Ausgang OUT des Busteilnehmers 2 bewirkbar. Bei Nicht-Aktivieren des ersten steuerbaren Halbeliteschalters T1 des Nachfolgers ist zwei Drittel der Versorgungsspannung am Ausgang OUT bewirkbar. Auf diese Weise ist das Anschließen des Nachfolgers an den Busteilnehmer 2 erkennbar. Da die Busteilnehmer 2 mittels einer Datenleitung miteinander verbunden sind, welche bis zur Steuerung 1 führt, ist somit erkennbar, ob ein Nachfolger zusätzlich angeschlossen wurde und die Steuerung 1 vergibt dann dem Nachfolger als neuem zusätzlichen Busteilnehmer 2 eine Adresse, also Busadresse.

Die Ansteuerung des ersten steuerbaren Halbleiters T1 ist am Ausgang IN_UC_N bewirkbar und die Ansteuerung des zweiten steuerbaren Halbleiterschalters T2 ist am Ausgang OUT_UC_N bewirkbar.

Bei gleichgroßer Dimensionierung der Widerstände R1, R2, R3, R4, R6, R7 ergibt sich folgendes Verhalten:
Ist am Busteilnehmer 2 kein Nachfolger angeschlossen, ist am Ausgang OUT des Busteilnehmers 2 die volle Versorgungsspannung detektierbar, also eine Spannung aus einem ersten Spannungswertenbereich.

Ist am Busteilnehmer 2 ein Nachfolger angeschlossen und mit einer Versorgungsspannung versorgt, ist am Ausgang OUT des Busteilnehmers 2 zwei Drittel der Versorgungsspannung detektierbar, also eine Spannung aus einem zweiten Spannungswertenbereich. Dabei sind die steuerbaren Halbleiterschalter T1 und T2 nicht angesteuert.

Ist am Busteilnehmer 2 ein Nachfolger angeschlossen, aber nicht mit einer Versorgungsspannung versorgt, ist am Ausgang OUT des Busteilnehmers 2 die halbe Versorgungsspannung detektierbar, also eine Spannung aus einem dritten Spannungswertebereich.

Ist am Busteilnehmer 2 ein Nachfolger angeschlossen und mit einer Versorgungsspannung versorgt, ist durch Ansteuern des zweiten steuerbaren Halbleiterschalters T2 des Busteilnehmers am Ausgang OUT des Busteilnehmers 2 zwei Drittel der Versorgungsspannung detektierbar, also eine Spannung aus einem zweiten Spannungswertenbereich bei Aktivieren, also bei Versetzen in den leitenden Zustand, des Halbleiterschalters T2. Bei Detektieren dieser Spannung wird der Nachfolger empfangsbereit und wartet auf die von der Steuerung 1 insbesondere als Broadcast, abgesandte Adresse. Auf diese Weise ist dem Nachfolger somit seine Adresse, also Busadresse, zugewiesen.

Ist am Ausgang des Busteilnehmers 2 eine verschwindend kleine Spannung, insbesondere Null, detektierbar, ist somit ein Abschlussstecker 3 erkannt. Die verschwindend kleine Spannung ist also aus einem vierten Spannungswertebereich.

Darüber hinaus ist es ausführbar, dass der Nachfolger seinen ersten steuerbaren Halbleiterschalter T1 aktiviert und somit an seinem Eingang IN, also auch am Ausgang OUT, des Busteilnehmers 2 zwei Drittel der Versorgungsspannung, also eine Spannung aus dem zweiten Spannungsbereich, erzeugt, wenn der zweite steuerbare Halbleiterschalter T2 des Busteilnehmers 2 noch nicht aktiviert ist, oder drei Viertel der Versorgungsspannung, also eine Spannung, die zwischen dem zweiten Spannungsbereich und dem ersten Spannungsbereich, wenn der zweite steuerbare Halbleiterschalter T2 des Busteilnehmers 2 aktiviert ist.

Der erste Spannungsbereich liegt dabei oberhalb des zweiten Spannungsbereichs.

Der zweite Spannungsbereich liegt dabei oberhalb des dritten Spannungsbereichs.

Der dritte Spannungsbereich liegt dabei oberhalb des vierten Spannungsbereichs.

Bei gleichgroßer Dimensionierung der Widerstände R1, R2, R3, R4, R6, R7 ergeben sich abweichende Spannungswerte, wobei für die Funktion der Erfindung nur die Anordnung und der Spannungsbereich relevant ist.

Vorteiligerweise sind die vier Dioden V2 der Schaltungsanordnung in einem gemeinsamen Bauteil integrierbar angeordnet. Ebenso sind der erste und der zweite steuerbare Halbleiterschalter in einem gemeinsamen Bauteil integriert angeordnet. Daher ist die Schaltungsanordnung durch eine Leiterplatte realisierbar, welche mit den beiden Bauteilen und den Widerständen bestückt ist, insbesondere in SMD-Technik. In Weiterbildung sind auch die Widerstände in einem gemeinsamen dritten Bauteil integriert ausgeführt, so dass die Schaltungsanordnung sehr kompakt herstellbar ist.

### Bezugszeichenliste

1 Steuerung
2 Busteilnehmer, insbesondere Wechselrichter
3 Abschlussstecker
R1 dritter Widerstand
R2 zweiter Widerstand
R3 vierte Widerstand
R4 erster Widerstand
R5 Widerstand
R6 Widerstand
C1 Kondensator
C2 Kondensator
C3 Kondensator
T1 erster steuerbarer Schalter
T2 zweiter steuerbarer Schalter
IN Eingang
OUT Ausgang
IN_UC Steuereingang
OUT_UC Steuereingang
U_Ref Versorgungsspannung

## Patentansprüche

1. System, aufweisend eine Steuerung und zumindest einen ersten Busteilnehmer und einen Nachfolger, also zweiten Busteilnehmer,
wobei die Steuerung mit dem ersten Busteilnehmer mittels eines Datenbusses, insbesondere CAN-Bus, RS485-Bus oder dergleichen, verbunden, insbesondere seriell verbunden, ist und der Nachfolger verbindbar ist,
wobei jeder Busteilnehmer, insbesondere der erste Busteilnehmer, jeweils eine erste Schaltungsanordnung aufweist, die zwischen einem Ausgang OUT des ersten Busteilnehmers und einem Eingang IN des ersten Busteilnehmers angeordnet ist,
wobei der Nachfolger eine zweite Schaltungsanordnung aufweist, die zwischen einem Ausgang OUT des Nachfolgers und einem Eingang IN des Nachfolgers angeordnet ist,
wobei die erste und zweite Schaltungsanordnung baugleich und/oder gleichartig ausgeführt sind,
wobei die erste und zweite Schaltungsanordnung einen Anschluss für eine Versorgungsspannung aufweisen,
**wobei** die erste Schaltungsanordnung ein Mittel zur Erfassung der am Ausgang OUT, insbesondere gegen Masse, anliegenden Spannung aufweist,
ein erster Widerstand R4 zwischen dem Ausgang OUT und dem Anschluss für Versorgungsspannung angeordnet ist,
**dadurch gekennzeichnet, dass**
ein zweiter Widerstand R2 zwischen dem Eingang IN und einem Anschluss für Masse angeordnet ist,
wobei mittels eines ersten steuerbaren Halbleiterschalters ein dritter Widerstand R1 zwischen dem Eingang IN und dem Anschluss für Versorgungsspannung anordenbar ist, insbesondere so dass der dritte Widerstand R1 parallel zum ersten Widerstand R4 angeordnet ist bei Verbinden des Nachfolgers mit dem ersten Busteilnehmer,
wobei mittels eines zweiten steuerbare Halbleiterschalters ein vierter Widerstand R3 zwischen dem Ausgang OUT und dem Anschluss für Versorgungsspannung anordenbar ist, insbesondere so dass der vierte Widerstand R3 parallel zum dritten Widerstand R1 angeordnet ist bei Verbinden des Nachfolgers mit dem ersten Busteilnehmer,
**am Eingang IN eine erste Schutzbeschaltung gegen zu niedrige und/oder zu hohe Spannungen angeordnet ist,**
**am Ausgang OUT eine zweite Schutzbeschaltung gegen zu niedrige und/oder zu hohe Spannungen angeordnet ist,**
**wobei zwischen dem Eingang IN und Masse ein erster Kondensator angeordnet ist,**
**wobei zwischen dem Ausgang OUT und Masse ein zweiter Kondensator angeordnet ist,**
**wobei die erste Schutzbeschaltung einen zwischen dem Eingang IN und einer ersten Diode angeordneten Widerstand R6 aufweist,**
**wobei die erste Diode derart zwischen dem Widerstand R6 und dem Anschluss für Versorgungsspannung angeordnet ist, dass dem Anschluss für Versorgungsspannung Strom durch die erste Diode hindurch zugeleitet wird, wenn am Eingang IN eine höhere Spannung als die Versorgungsspannung anliegt,**
**wobei eine zweite Diode zwischen dem Widerstand R6 und Masse derart angeordnet ist, dass der Masse Strom durch die zweite Diode hindurch zugeleitet wird, wenn am Eingang IN eine negative Spannung anliegt.**

2. System nach Anspruch 1,
**dadurch gekennzeichnet, dass**
der Eingang IN des Nachfolgers mit dem Ausgang OUT des ersten Busteilnehmers verbindbar ist.

3. System nach einem der vorangegangenen Ansprüche,
**dadurch gekennzeichnet, dass**
der Nachfolger ein Mittel zur Erfassung der am Eingang IN des Nachfolgers, insbesondere gegen Masse, anliegenden Spannung aufweist,
insbesondere wobei der Nachfolger ein Mittel zur Erfassung der am Ausgang OUT des Nachfolgers, insbesondere gegen Masse, anliegenden Spannung aufweist.

4. System nach einem der vorangegangenen Ansprüche,
**dadurch gekennzeichnet, dass**
der erste Busteilnehmer ein Mittel zur Erfassung der am Eingang IN des ersten Busteilnehmers, insbesondere gegen Masse, anliegenden Spannung aufweist.

5. System nach einem der vorangegangenen Ansprüche,
**dadurch gekennzeichnet, dass**
die zweite Schutzbeschaltung einen zwischen dem Ausgang OUT und einer dritten Diode angeordneten Widerstand R7 aufweist,
wobei die dritte Diode derart zwischen dem Widerstand R7 und dem Anschluss für Versorgungsspannung angeordnet ist, dass dem Anschluss für Versorgungsspannung Strom durch die dritte Diode hindurch zugeleitet wird, wenn am Ausgang OUT eine höhere Spannung als die Versorgungsspannung anliegt,
insbesondere wobei eine vierte Diode zwischen dem Widerstand R7 und Masse derart angeordnet ist, dass der Masse Strom durch die vierte Diode hindurch zugeleitet wird, wenn am Ausgang OUT eine negative Spannung anliegt.

6. System nach einem der vorangegangenen Ansprüche,
**dadurch gekennzeichnet, dass**
der erste und der zweite steuerbare Halbleiterschalter der ersten Schaltungsanordnung in einem ersten Bauteil integriert angeordnet sind.

7. System nach einem der vorangegangenen Ansprüche,
**dadurch gekennzeichnet, dass**
die erste, zweite, dritte, vierte Diode der ersten Schaltungsanordnung in einem zweiten Bauteil integriert angeordnet sind.

8. System nach einem der vorangegangenen Ansprüche,
**dadurch gekennzeichnet, dass**
die erste Schaltungsanordnung eine Leiterplatte aufweist, auf welcher das erste und das zweite Bauteil bestückt sind, insbesondere mittels SMD-Technik.

9. Verfahren zum Betreiben eines Systems, aufweisend eine Steuerung und zumindest einen ersten Busteilnehmer und einen Nachfolger, also zweiten Busteilnehmer,
wobei die Steuerung mit dem ersten Busteilnehmer mittels eines Datenbusses, insbesondere CAN-Bus, RS485-Bus oder dergleichen, verbunden, insbesondere seriell verbunden, ist und der Nachfolger verbindbar ist,
wobei jeder Busteilnehmer, insbesondere der erste Busteilnehmer, jeweils einen aktivierbaren Ausgang und einen aktivierbaren Eingang aufweist,
wobei der Nachfolger ebenfalls einen aktivierbaren Ausgang und einen aktivierbaren Eingang aufweist,
wobei jeder Ausgang abhängig von seiner Aktivierung einen ersten oder zweiten Widerstandswert zu einem Anschluss für Versorgungsspannung aufweist,
wobei jeder Eingang abhängig von seiner Aktivierung einen dritten oder vierten Widerstandswert zur Masse, also zum Nullpotential, des Nachfolgers hinaufweist,
wobei die am Ausgang des ersten Busteilnehmers anliegende Spannung erfasst wird und abhängig von der erfassten Spannung unter Berücksichtigung des Aktivierungszustands des Ausgangs des ersten Busteilnehmers erkannt wird,
- ob mit dem ersten Busteilnehmer kein Nachfolger verbunden ist, insbesondere also der Ausgang offen ist,
- ob mit dem ersten Busteilnehmer ein Nachfolger verbunden ist, der keine Versorgungsspannung aufweist,
- ob mit dem ersten Busteilnehmer ein Nachfolger verbunden ist, der von einer Versorgungsspannung versorgt ist und dessen Eingang aktiviert ist,
- ob mit dem ersten Busteilnehmer ein Nachfolger verbunden ist, der von einer Versorgungsspannung versorgt ist und dessen Eingang nicht aktiviert ist,
- ob mit dem ersten Busteilnehmer ein Abschlussstecker verbunden ist, insbesondere also der Ausgang elektrisch mit Masse verbunden ist.,
**dadurch gekennzeichnet, dass**
entschieden wird, ob die erfasste Spannung in einem ersten, zweiten, dritten oder vierten Spannungsbereich enthalten ist,
wobei der erste Spannungsbereich oberhalb des zweiten Spannungsbereich ist, wobei der zweite Spannungsbereich oberhalb des dritten Spannungsbereichs ist,
wobei der dritte Spannungsbereich oberhalb des vierten Spannungsbereichs ist.
- **wobei der erste** Spannungsbereich die Information codiert, dass mit dem ersten Busteilnehmer kein Nachfolger verbunden ist, insbesondere also der Ausgang offen ist,
- **wobei der dritte** Spannungsbereich die Information codiert, dass mit dem ersten Busteilnehmer ein Nachfolger verbunden ist, der keine Versorgungsspannung aufweist,
- **wobei ein weiterer** Spannungsbereich die Information codiert, dass mit dem ersten Busteilnehmer ein Nachfolger verbunden ist, der von einer Versorgungsspannung versorgt ist und dessen Eingang aktiviert ist,
- **wobei der zweite** Spannungsbereich die Information codiert, dass mit dem ersten Busteilnehmer ein Nachfolger verbunden ist, der von einer Versorgungsspannung versorgt ist und dessen Eingang nicht aktiviert ist,
- wobei der **vierte** Spannungsbereich die Information codiert, dass mit dem ersten Busteilnehmer ein Abschlussstecker verbunden ist, insbesondere also der Ausgang elektrisch mit Masse verbunden ist.

10. Verfahren **nach Anspruch 9,**
**dadurch gekennzeichnet, dass**
abhängig von der erfassten Spannung und abhängig von dem Aktivierungszustand des Ausgangs des ersten Busteilnehmers
- ein jeweiliger Zustand, insbesondere Fehlerzustand, vom ersten Busteilnehmer gemeldet wird
oder die Vergabe einer Adresse angefordert wird, insbesondere der Empfang der Adresse insbesondere vom Nachfolger, quittiert wird.

## Claims

1. System comprising a controller and at least a first bus participant and a successor, i.e. a second bus participant,
wherein the controller is connected, in particular is serially connected, and the successor can be connected to the first bus participant by means of a data bus, in particular a CAN bus, an RS485 bus or the like,
wherein each bus participant, in particular the first bus participant, comprises a first circuit arrangement which is arranged between an output OUT of the first bus participant and an input IN of the first bus participant,
wherein the successor comprises a second circuit arrangement which is arranged between an output OUT of the successor and an input IN of the successor,
wherein the first and the second circuit arrangement are of identical and/or similar configuration,
wherein the first and the second circuit arrangement have a supply voltage terminal,
wherein the first circuit arrangement has a means for detecting the voltage, in particular to ground, that is present at the output OUT,
a first resistor R4 is arranged between the output OUT and the supply voltage terminal,
**characterized in that**
a second resistor R2 is arranged between the input IN and a ground terminal,
wherein by means of a first controllable semiconductor switch a third resistor R1 can be arranged between the input IN and the supply voltage terminal, in particular such that the third resistor R1 is arranged in parallel with the first resistor R4 when the successor is connected to the first bus participant, wherein by means of a second controllable semiconductor switch a fourth resistor R3 can be arranged between the output OUT and the supply voltage terminal, in particular such that the fourth resistor R3 is arranged in parallel with the third resistor R1 when the successor is connected to the first bus participant,
a first protection circuit against excessively low and/or excessively high voltages is arranged at the input IN,
a second protection circuit against excessively low and/or excessively high voltages is arranged at the output OUT, wherein a first capacitor is arranged between the input IN and ground,
wherein a second capacitor is arranged between the output OUT and ground,
wherein the first protection circuit has a resistor R6 arranged between the input IN and a first diode,
wherein the first diode is arranged between the resistor R6 and the supply voltage terminal such that current is supplied to the supply voltage terminal through the first diode when a voltage higher than the supply voltage is present at the input IN,
wherein a second diode is arranged between the resistor R6 and ground such that current is supplied to ground through the second diode when a negative voltage is present at the input IN.

2. System according to claim 1,
**characterized in that**
the input IN of the successor can be connected to the output OUT of the first bus participant.

3. System according to any one of the preceding claims, **characterized in that**
the successor has a means for detecting the voltage, in particular to ground, that is present at the input IN of the successor,
in particular wherein the successor has a means for detecting the voltage, in particular to ground, that is present at the output OUT of the successor.

4. System according to any one of the preceding claims, **characterized in that**
the first bus participant has a means for detecting the voltage, in particular to ground, that is present at the input IN of the first bus participant.

5. System according to any one of the preceding claims, **characterized in that**
the second protection circuit has a resistor R7 arranged between the output OUT and a third diode,
wherein the third diode is arranged between the resistor R7 and the supply voltage terminal such that current is supplied to the supply voltage terminal through the third diode when a voltage higher than the supply voltage is present at the output OUT,
in particular wherein a fourth diode is arranged between the resistor R7 and ground such that current is supplied to ground through the fourth diode when a negative voltage is present at the output OUT.

6. System according to any one of the preceding claims, **characterized in that**
the first and the second controllable semiconductor switch of the first circuit arrangement are integrated in a first component.

7. System according to any one of the preceding claims, **characterized in that**
the first, second, third and fourth diode of the first circuit arrangement are integrated in a second component.

8. System according to any one of the preceding claims, **characterized in that**
the first circuit arrangement comprises a printed circuit board, on which the first and the second component are mounted, in particular by means of SMD technology.

9. Method for operating a system comprising a controller and at least a first bus participant and a successor, i.e. a second bus participant,
wherein the controller is connected, in particular is serially connected, and the successor can be connected to the first bus participant by means of a data bus, in particular a CAN bus, an RS485 bus or the like,
wherein each bus participant, in particular the first bus participant, has an activatable output and an activatable input, wherein the successor likewise has an activatable output and an activatable input,
wherein each output, depending on its activation, has a first or second resistance value relative to a supply voltage terminal,
wherein each input, depending on its activation, has a third or fourth resistance value relative to the ground, i.e. the zero potential, of the successor,
wherein the voltage present at the output of the first bus participant is detected and, depending on the detected voltage and taking into account the state of activation of the output of the first bus participant, it is recognized
- whether no successor is connected to the first bus participant, i.e. in particular the output is open,
- whether a successor that has no supply voltage is connected to the first bus participant,
- whether a successor that is supplied with a supply voltage and whose input is activated is connected to the first bus participant,
- whether a successor that is supplied with a supply voltage and whose input is not activated is connected to the first bus participant,
- whether a terminating plug is connected to the first bus participant, i.e. in particular the output is electrically connected to ground,
**characterized in that**
it is decided whether the detected voltage is in a first, second, third or fourth voltage range,
wherein the first voltage range is above the second voltage range,
wherein the second voltage range is above the third voltage range,
wherein the third voltage range is above the fourth voltage range,
- wherein the first voltage range codes for the information that no successor is connected to the first bus participant, i.e. in particular the output is open,
- wherein the third voltage range codes for the information that a successor that has no supply voltage is connected to the first bus participant,
- wherein a further voltage range codes for the information that a successor that is supplied with a supply voltage and whose input is activated is connected to the first bus participant,
- wherein the second voltage range codes for the information that a successor that is supplied with a supply voltage and whose input is not activated is connected to the first bus participant,
- wherein the fourth voltage range codes for the information that a terminating plug is connected to the first bus participant, i.e. in particular the output is electrically connected to ground.

10. Method according to claim 9,
**characterized in that**
depending on the detected voltage and depending on the state of activation of the output of the first bus participant,
- a respective state, in particular error state, is signaled by the first bus participant
or the assignment of an address is requested, in particular receipt of the address in particular by the successor is acknowledged.

## Revendications

1. Système, comprenant une commande et au moins un premier composant de bus et un successeur, c'est-à-dire un second composant de bus,
le système de commande étant connecté, en particulier connecté en série, et le successeur pouvant être connecté, au premier composant de bus au moyen d'un bus de données, en particulier d'un bus CAN, d'un bus RS485 ou similaire,
chaque composant de bus, en particulier le premier composant de bus, présentant respectivement un premier circuit agencé entre une sortie OUT du premier composant de bus et une entrée IN du premier composant de bus,
le successeur présentant un second circuit agencé entre une sortie OUT du successeur et une entrée IN du successeur,
les premier et second circuits étant de construction identique et/ou étant réalisés de manière similaire,
les premier et second circuits présentant une borne de tension d'alimentation,
le premier circuit présentant un moyen permettant de détecter la tension appliquée à la sortie OUT, en particulier par référence à la masse,
une première résistance R4 est agencée entre la sortie OUT et la borne de tension d'alimentation,
**caractérisé en ce que**
une deuxième résistance R2 est agencée entre l'entrée IN et une borne destinée à la masse,
une troisième résistance R1 pouvant être agencée entre l'entrée IN et la borne de tension d'alimentation au moyen d'un premier contacteur à semi-conducteur commandable, en particulier de sorte que la troisième résistance R1 soit agencée parallèlement à la première résistance R4 lors de la connexion du successeur au premier composant de bus,
une quatrième résistance R3 pouvant être agencée entre la sortie OUT et la borne de tension d'alimentation au moyen d'un deuxième contacteur à semi-conducteur commandable, en particulier de sorte que la quatrième résistance R3 soit agencée parallèlement à la troisième résistance R1 lors de la connexion du successeur au premier composant de bus,
un premier circuit de protection contre les tensions trop basses et/ou trop élevées est agencé au niveau de l'entrée IN,
un deuxième circuit de protection contre les tensions trop basses et/ou trop élevées est agencé au niveau de la sortie OUT,
un premier condensateur étant agencé entre l'entrée IN et la masse,
un deuxième condensateur étant agencé entre la sortie OUT et la masse,
le premier circuit de protection présentant une résistance R6 agencée entre l'entrée IN et une première diode,
la première diode étant agencée entre la résistance R6 et la borne de tension d'alimentation de telle manière que le courant traverse la première diode vers la borne de tension d'alimentation lorsqu'une tension plus élevée que la tension d'alimentation est appliquée à l'entrée IN,
une deuxième diode étant agencée entre la résistance R6 et la masse de telle manière que le courant traverse la deuxième diode vers la masse lorsqu'une tension négative est appliquée à l'entrée IN.

2. Système selon la revendication 1,
**caractérisé en ce que**
l'entrée IN du successeur peut être connectée à la sortie OUT du premier composant de bus.

3. Système selon l'une quelconque des revendications précédentes,
**caractérisé en ce que**
le successeur présente un moyen permettant de détecter la tension appliquée à l'entrée IN du successeur, en particulier par référence à la masse,
le successeur présentant en particulier un moyen permettant de détecter la tension appliquée à la sortie OUT du successeur, en particulier par référence à la masse.

4. Système selon l'une quelconque des revendications précédentes,
**caractérisé en ce que**
le premier composant de bus présente un moyen permettant de détecter la tension appliquée à l'entrée IN du premier composant de bus, en particulier par référence à la masse.

5. Système selon l'une quelconque des revendications précédentes,
**caractérisé en ce que**
le deuxième circuit de protection présente une résistance R7 agencée entre la sortie OUT et une troisième diode,
la troisième diode étant agencée entre la résistance R7 et la borne de tension d'alimentation de telle manière que le courant traverse la troisième diode vers la borne de tension d'alimentation lorsqu'une tension plus élevée que la tension d'alimentation est appliquée à la sortie OUT,
une quatrième diode étant en particulier agencée entre la résistance R7 et la masse de telle manière que le courant traverse la quatrième diode vers la masse lorsqu'une tension négative est appliquée à la sortie OUT.

6. Système selon l'une quelconque des revendications précédentes,
**caractérisé en ce que**
les premier et second contacteurs à semi-conducteur commandables du premier circuit sont agencés dans un premier élément.

7. Système selon l'une quelconque des revendications précédentes,
**caractérisé en ce que**
les première, deuxième, troisième et quatrième diodes du premier circuit sont agencées dans un second élément.

8. Système selon l'une quelconque des revendications précédentes,
**caractérisé en ce que**
le premier circuit comporte une carte de circuit imprimé sur laquelle sont montés les premier et second éléments, en particulier au moyen de la technique CMS.

9. Procédé permettant de faire fonctionner un système, comprenant une commande et au moins un premier composant de bus et un successeur, c'est-à-dire un second composant de bus,
la commande étant connectée, en particulier connectée en série, et le successeur pouvant être connecté, au premier composant de bus au moyen d'un bus de données, en particulier d'un bus CAN, d'un bus RS485 ou similaire,
chaque composant de bus, en particulier le premier composant de bus, présentant respectivement une sortie pouvant être activée et une entrée pouvant être activée,
le successeur présentant également une sortie pouvant être activée et une entrée pouvant être activée,
chaque sortie présentant, en fonction de son activation, une première ou une deuxième valeur de résistance par rapport à une borne de tension d'alimentation, chaque entrée présentant, en fonction de son activation, une troisième ou une quatrième valeur de résistance par rapport à la masse, c'est-à-dire au potentiel zéro, du successeur,
la tension appliquée à la sortie du premier composant de bus étant détectée et
une reconnaissance étant mise en oeuvre en fonction de la tension détectée et en tenant compte de l'état d'activation de la sortie du premier composant de bus afin de déterminer
- si aucun successeur n'est connecté au premier composant de bus, en particulier donc si la sortie est ouverte,
- si un successeur ne présentant pas de tension d'alimentation est connecté au premier composant de bus,
- si un successeur alimenté par une tension d'alimentation et dont l'entrée est activée est connecté au premier composant de bus,
- si un successeur alimenté par une tension d'alimentation et dont l'entrée n'est pas activée est connecté au premier composant de bus,
- si une fiche de borne est connectée au premier composant de bus, en particulier donc si la sortie est connectée électriquement à la masse,
**caractérisé en ce que**
une décision est prise quant au fait que la tension détectée est comprise dans une première, une deuxième, une troisième ou une quatrième plage de tension,
la première plage de tension se situant au-dessus de la deuxième plage de tension, la deuxième plage de tension se situant au-dessus de la troisième plage de tension, la troisième plage de tension se situant au-dessus de la quatrième plage de tension,
- la première plage de tension codant l'information selon laquelle aucun successeur n'est connecté au premier composant de bus, en particulier donc selon laquelle la sortie est ouverte,
- la troisième plage de tension codant l'information selon laquelle un successeur ne présentant pas de tension d'alimentation est connecté au premier composant de bus,
- une plage supplémentaire de tension codant l'information selon laquelle un successeur, alimenté par une tension d'alimentation et dont l'entrée est activée, est connecté au premier composant de bus,
- la deuxième plage de tension codant l'information selon laquelle un successeur, alimenté par une tension d'alimentation et dont l'entrée n'est pas activée, est connecté au premier composant de bus,
- la quatrième plage de tension codant l'information selon laquelle une fiche de borne est connectée au premier composant de bus, en particulier donc selon laquelle la sortie est connectée électriquement à la masse.

10. Procédé selon la revendication 9,
**caractérisé en ce que**
en fonction de la tension détectée et en fonction de l'état d'activation de la sortie du premier composant de bus
- un état respectif, en particulier un état d'erreur, est signalé par le premier composant de bus
ou l'attribution d'une adresse est demandée, en particulier la réception de l'adresse, en particulier par le successeur, est confirmée.
